(19) Europäisches Patentamt
European Patent Office
Office européen des brevets

(11) **EP 1 811 673 B1**

(12) **FASCICULE DE BREVET EUROPEEN**

(45) Date de publication et mention
de la délivrance du brevet:
**08.10.2008 Bulletin 2008/41**

(51) Int Cl.:
*H03M 1/10* *(2006.01)*     *H03M 1/06* *(2006.01)*

(21) Numéro de dépôt: **06127164.9**

(22) Date de dépôt: **22.12.2006**

(54) **Dispositif de conversion analogique numérique à entrelacement temporel et à égalisation auto adaptative**

Vorrichtung zur Analog/Digital-Umwandlung mit zeitlicher Verschachtelung und automatischer Einregelung

Analogue-to-digital conversion device using time interleave and self-adaptive equalisation

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **06.01.2006 FR 0600121**

(43) Date de publication de la demande:
**25.07.2007 Bulletin 2007/30**

(73) Titulaire: **THALES**
**92200 Neuilly sur Seine (FR)**

(72) Inventeur: **Buisson, Philippe**
**95170 Deuil la Barre (FR)**

(74) Mandataire: **Lucas, Laurent Jacques**
**Marks & Clerk France**
**31-33 Avenue Aristide Briand**
**94117 Arcueil Cedex (FR)**

(56) Documents cités:
**EP-A- 1 401 105          US-A- 5 239 299**

- **PATENT ABSTRACTS OF JAPAN vol. 2003, no. 12, 5 décembre 2003 (2003-12-05) -& JP 2004 328436 A (ANRITSU CORP), 18 novembre 2004 (2004-11-18)**
- **DYER K ET AL: "Analog background calibration of a 10 b 40 Msample/s parallel pipelined ADC" SOLID-STATE CIRCUITS CONFERENCE, 1998. DIGEST OF TECHNICAL PAPERS. 1998 IEEE INTERNATIONAL SAN FRANCISCO, CA, USA 5-7 FEB. 1998, NEW YORK, NY, USA,IEEE, US, 5 février 1998 (1998-02-05), pages 142-143,427, XP010278598 ISBN: 0-7803-4344-1**
- **HUMMELS D M ET AL: "Distortion compensation for time-interleaved analog to digital converters" 4 juin 1996 (1996-06-04), INSTRUMENTATION AND MEASUREMENT TECHNOLOGY CONFERENCE, 1996. IMTC-96. CONFERENCE PROCEEEDINGS. QUALITY MEASUREMENTS: THE INDISPENSABLE BRIDGE BETWEEN THEORY AND REALITY., IEEE BRUSSELS, BELGIUM 4-6 JUNE 1996, NEW YORK, NY, USA, IEEE, US, PAGE(S) 728-7 , XP010163973 ISBN: 0-7803-3312-8 * page 728, colonne de gauche, alinéa 1 * * page 728, colonne de droite, alinéa 2 - page 731, colonne de gauche, alinéa 1; figures 1,5,6 ***

**Description**

L'invention concerne un dispositif de conversion analogique numérique à entrelacement temporel égalisé. En particulier, l'invention s'applique aux convertisseurs analogique numérique fonctionnant à une fréquence d'horloge élevée, typiquement de l'ordre du gigahertz.

Une des caractéristiques d'un convertisseur analogique numérique est sa fréquence d'échantillonnage, c'est-à-dire le nombre d'échantillons numériques d'un signal analogique qu'il est capable de produire par unité de temps. Chaque convertisseur analogique numérique comporte notamment une horloge délivrant un signal pilotant la fréquence à laquelle les échantillons numériques sont produits. La fréquence d'échantillonnage maximale constitue donc une limite intrinsèque d'un convertisseur analogique numérique. Lorsque l'on souhaite échantillonner à une fréquence élevée, typiquement de l'ordre du gigahertz, il est possible de choisir un convertisseur analogique numérique disposant d'une fréquence d'échantillonnage correspondante dans la mesure où un composant disposant d'une telle caractéristique existe. Or le coût d'un tel composant dépend notamment de sa fréquence d'échantillonnage maximale, et augmente avec celle-ci.

Une autre solution, regroupant communément les convertisseurs analogique numérique à entrelacement temporel, est de faire fonctionner en parallèle un nombre N de convertisseurs analogique numérique, chacun utilisant alors une horloge dont la fréquence est N fois plus faible que la fréquence d'échantillonnage souhaitée $F_e$. L'horloge de chaque convertisseur analogique numérique est décalée temporellement par rapport à celle du convertisseur analogique numérique le précédent d'une période de l'horloge d'échantillonnage souhaitée $F_e$. On obtient de la sorte l'équivalent d'un convertisseur fonctionnant à la fréquence d'échantillonnage souhaitée $F_e$ avec N convertisseurs analogique numérique en parallèle, fonctionnant chacun à une fréquence d'échantillonnage $\dfrac{F_e}{N}$ . Cette solution implique une grande similitude des caractéristiques des convertisseurs analogique numérique. Parmi les caractéristiques qui doivent présenter de grandes similitudes, on peut notamment citer la tension de décalage et le gain du signal numérique de sortie de chaque convertisseur analogique numérique. En outre, les horloges des convertisseurs analogique numérique doivent être synchronisées précisément afin d'échantillonner à l'instant souhaité. La bande passante du signal analogique qu'un convertisseur analogique numérique est capable de recevoir en entrée doit de plus être la même pour tous les convertisseurs analogique numérique.

Il est donc particulièrement complexe et délicat de réunir l'ensemble de ces conditions. Les disparités entre les convertisseurs analogique numérique entraînent l'apparition d'erreurs dans le signal numérique de sortie. Aussi, le signal numérique de sortie des convertisseurs analogique numérique à entrelacement temporel s'en trouve donc notablement dégradé.

Il est toutefois encore possible de corriger partiellement ce type d'erreur par des techniques de filtrage numérique connues. Cependant, ces techniques de filtrage nécessitent une phase d'initialisation, où des mesures d'erreurs sont réalisées sur le signal numérique de sortie des convertisseurs analogique numérique. Les moyens de filtrage numérique, une fois l'erreur en partie caractérisée après la phase d'initialisation, s'appliquent à corriger le signal numérique de sortie. Or, ces moyens de filtrage numérique s'adaptent mal aux variations de fréquence et de niveau du signal d'entrée au cours du temps, d'autant plus que ces variations sont rapides, ce qui est le cas des signaux présentant une dynamique importante.

Un premier document, JP 2004 328436 A, décrit un convertisseur analogique numérique. Un deuxième document, US-A-5 239 299, décrit une égalisation numérique d'un convertisseur analogique numérique à entrelacement temporel. Un troisième document, DYER K. et al. Analog Background Calibration of a 10 b 40 Msample/s Parallel Pipelined ADC, Solid-State Circuits Conférence, 1998, Digest of Technical Papers. 1998 IEEE International San Francisco, CA, USA 5-7 Feb. 1998, New York, NY, USA, IEEE, US, 5 février 1998, pages 142-143, 427, décrit un "Analog Background-Calibration of a 10b 40MSample/s Parallel Pipelined ABC".

L'invention a notamment pour but de remédier aux inconvénients précités. A cet effet, l'invention a pour objet un dispositif de conversion analogique numérique recevant en entrée un signal analogique et délivrant en sortie un signal numérique à une fréquence d'échantillonnage souhaitée. Le dispositif comporte un nombre N de convertisseurs analogique numérique répartis en N voies. Chaque convertisseur analogique numérique a une fréquence d'échantillonnage N fois plus faible que la fréquence d'échantillonnage souhaitée. Les convertisseurs analogique numérique ont des signaux d'horloge pilotant leur fréquence d'échantillonnage décalés temporellement les uns par rapport aux autres d'une période d'un signal de fréquence d'échantillonnage souhaitée. Le signal numérique est construit à partir des échantillons délivrés en sortie de chaque voie. Le dispositif comporte une voie de référence comportant un convertisseur analogique numérique générant des échantillons du signal analogique. Chaque voie comporte un filtre égaliseur. Le filtre reçoit en entrée un signal numérique délivré par le convertisseur analogique numérique de la voie sur laquelle il est situé. Le filtre reçoit aussi un signal d'erreur et délivre en sortie un signal numérique filtré s(n) corrigé des erreurs déduites du signal d'erreur. Le signal d'erreur correspond à l'écart à un instant donné entre d'une part le signal numérique corrigé par le filtre et d'autre part par le signal numérique délivré par le convertisseur analogique numérique de la voie de référence.

Avantageusement, les coefficients dudit filtre s'ajustent pour présenter la réponse qui minimise au mieux le signal d'erreur.

Dans un mode de réalisation, le signal d'erreur correspond à l'écart à un instant donné entre d'une part le signal numérique corrigé à la fois par le filtre et par un dispositif de correction du décalage et d'autre part par le signal numérique délivré par le convertisseur analogique numérique de la voie de référence. Le dispositif de correction du décalage délivre un signal d'erreur de décalage $Y_n$. Le signal d'erreur de décalage $Y_n$ est généré à un instant n en appliquant la relation mathématique suivante : $y_{n+1} = y_n + err_n * \mu$ à l'instant n avec $err_n$ la valeur du signal d'erreur à un instant n et $\mu$ une valeur de paramétrage.

Dans un autre mode de réalisation, une fois que le convertisseur analogique numérique de la voie de référence a généré un échantillon au même instant que la voie disposée en $i^{ème}$ position avec i compris entre 1 et N, le convertisseur analogique numérique de la voie de référence génèrera le prochain échantillon au même instant que sur la voie disposée en $(i+1 \text{ modulo } N)^{ème}$ position.

En outre, le filtre de chaque voie peut être un filtre à réponse impulsionnelle finie auto adaptatif, comportant $2.q + 1$ coefficients, q étant un entier. L'adaptation des coefficients des filtres de chaque voie peut être réalisée par un algorithme de gradient.

Avantageusement, pour i entier variant de 2 à q, les coefficients $C_i$, sont définis par une relation fixée entre eux. Par exemple, le coefficient central $C_0$ et le premier coefficient $C_1$ du filtre sont mis à jour par une méthode d'auto adaptation, le coefficient $C_{-1}$ étant égal à $- C_1$, les coefficients $C_{-i}$, pour i variant de 2 à q, étant égaux à $-C_i$, les coefficients $C_i$, pour i variant de 2 à q, étant déterminés à partir de $C_1$ par la relation suivante : $C_i = \dfrac{k(i).C_1}{((-1)^{i+1}.i)}$ avec un facteur $k(i)$ dépendant de i. Le facteur $k(i)$ peut être choisi décroissant et variant sensiblement de 1 pour i proche de 2 vers zéro pour i tendant vers $2q+1$.

Dans un mode particulier de réalisation, le coefficient central $C_0$ et le premier coefficient $C_1$ du filtre sont mis à jour par une méthode d'auto adaptation, le coefficient $C_{-1}$ étant égal à $-C_1$, les coefficients $C_{-i}$, pour i variant de 2 à q, étant égaux à $-C_i$, les coefficients $C_i$, pour i variant de 2 à q, étant déterminés à partir de $C_1$ par la relation suivante :

$$C_i = \frac{C_1}{-i} \text{ pour i pair et } C_i = \frac{C_1}{i} \text{ pour i impair.}$$

Le filtre de chaque voie peut fonctionner à la fréquence d'échantillonnage souhaitée, en sur-échantillonnant dans un rapport N à l'entrée dudit filtre (20). Les échantillons disponibles à un instant donné sur l'une des autres voies peuvent alors être utilisés à l'entrée dudit filtre, les échantillons alimentant le filtre à la fréquence d'échantillonnage souhaitée.

L'invention a notamment pour avantages qu'elle permet de corriger le signal numérique sans calibration ni réglage préalable, ce qui la rend insensible aux variations de température notamment. De plus, l'invention présente une grande reproductibilité et facilité de mise en oeuvre.

D'autres caractéristiques et avantages de l'invention apparaîtront à l'aide de la description qui suit faite en regard des dessins annexés qui représentent :

- la figure 1a, un dispositif de conversion analogique numérique comportant plusieurs convertisseurs analogique numérique en parallèle, selon l'état de l'art ;

- la figure 1b, le signal d'horloge des différents convertisseurs analogique numérique du dispositif de conversion analogique numérique selon l'état de l'art ;

- la figure 2, la structure d'une voie du dispositif de conversion analogique numérique selon l'invention ;

- la figure 3, les instants d'échantillonnage des convertisseurs numérique analogique des différentes voies du dispositif de conversion analogique numérique selon l'invention ;

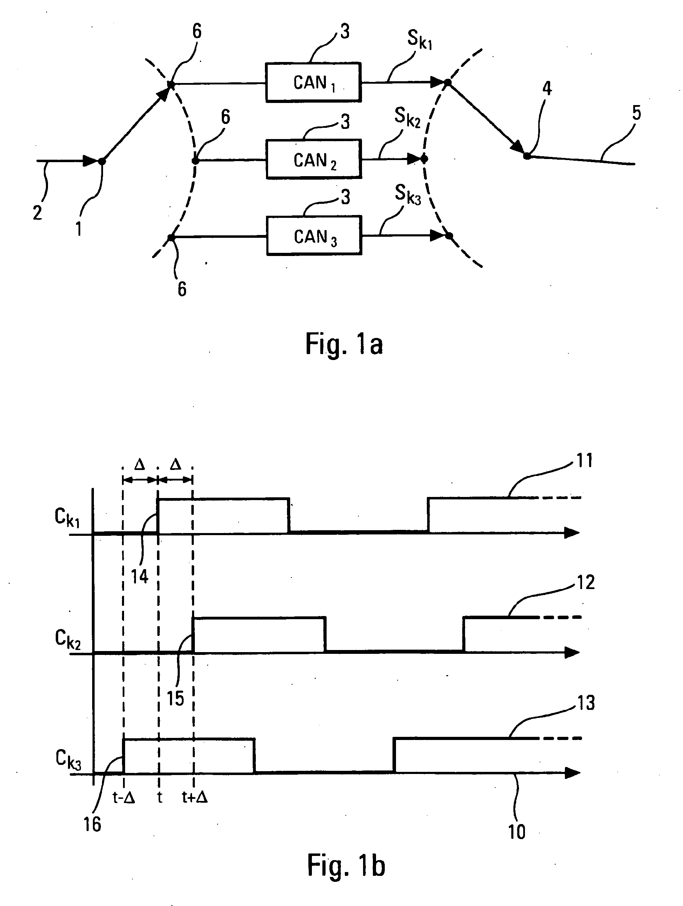

La figure 1a illustre un dispositif de conversion analogique numérique comportant plusieurs convertisseurs analogique numérique en parallèle, selon l'état de l'art.

Comme illustré sur la figure 1a, le dispositif de conversion analogique numérique reçoit un signal analogique 2 sur une entrée 1 et délivre en sortie un signal numérique 5 sur sortie 4. Le signal numérique 5 comporte des échantillons numériques du signal analogique 2. La fréquence d'apparition des échantillons numériques est égale à une fréquence donnée, dite fréquence d'échantillonnage souhaitée $F_e$. Le dispositif de conversion analogique numérique comporte en outre un nombre N de convertisseurs analogique numérique 3 répartis en N voies 6. Dans l'exemple de la figure 1a, les convertisseurs analogique numérique 3 sont au nombre de trois : un premier $CAN_1$ sur une voie 6 délivrant en sortie un signal numérique $S_{K1}$, un second $CAN_2$ sur une voie 6 délivrant en sortie un signal numérique $S_{K2}$, et le troisième $CAN_3$ sur une voie 6 délivrant en sortie un signal numérique $S_{K3}$. Chaque convertisseur analogique numérique 3 comporte notamment une horloge délivrant un signal pilotant la fréquence à laquelle les échantillons numériques sont produits ainsi que le moment où les échantillons numériques sont prélevés sur le signal analogique 2. La fréquence d'horloge de chaque convertisseur analogique numérique 3 est choisie N fois plus faible que la fréquence d'échantillonnage souhaitée $F_e$.

La figure 1b illustre par un chronogramme le signal d'horloge des différents convertisseurs analogique numérique du dispositif de conversion analogique numérique selon l'état de l'art. Le temps est représenté par un axe des abscisses 10. Une courbe 11 représente le signal d'horloge du convertisseur analogique numérique 3 $CAN_1$. Le signal d'horloge représenté par la courbe 11 comporte notamment à l'instant t un front montant 14. Une courbe 12 représente le signal d'horloge du convertisseur analogique numérique 3 $CAN_2$. Le signal d'horloge représenté par la courbe 12 comporte notamment à l'instant t+$\Delta$ un front montant 15. Une courbe 13 représente le signal d'horloge du convertisseur analogique numérique 3 $CAN_3$. Le signal d'horloge représentée par la courbe 13 comporte notamment à l'instant t-$\Delta$ un front montant 15. Le signal d'horloge de chaque convertisseur analogique numérique 3 est décalé par rapport à celle du convertisseur analogique numérique précédent d'une période $\Delta$ de l'horloge fonctionnant à la fréquence d'échantillonnage souhaitée $F_e$. Le dispositif de conversion analogique numérique selon l'état de l'art présenté est couramment désigné par le terme de convertisseur analogique numérique à entrelacement temporel.

Sur la figure 1a, le signal numérique 5 est construit alternativement à partir des signaux $S_{K1}$, $S_{K2}$, $S_{K3}$ délivrés par les convertisseurs analogique numérique $CAN_1$, $CAN_2$ et $CAN_3$. On obtient de la sorte l'équivalent d'un convertisseur analogique numérique fonctionnant à la fréquence d'échantillonnage souhaitée $F_e$ avec N convertisseurs analogique numérique 3 mis en parallèle, fonctionnant chacun à une fréquence d'échantillonnage $\dfrac{F_e}{N}$ .

Le dispositif de conversion analogique numérique génère en sortie 4 un signal numérique 5 entaché notamment par les erreurs dues aux disparités entre les convertisseurs analogique numérique 3. Parmi ces erreurs, on peut notamment citer :

- les erreurs de décalage ou selon l'expression anglo-saxonne d'offset du signal numérique délivré par les différents convertisseurs analogique numérique 3, provoquant dans le spectre du signal numérique 5 l'apparition de raies, aux fréquences $k\dfrac{F_e}{N}$ pour k variant de 0 à N - 1, dont l'amplitude est liée aux erreurs de décalage inter voies 6 ;

- les erreurs de gain correspondant aux différences de gain entre voies 6 provoquant dans le spectre du signal numérique 5 l'apparition de raies, aux fréquences $k\dfrac{F_e}{N} \pm F_{in}$ pour k variant de 0 à N - 1 et $F_{in}$ étant la fréquence du signal analogique 2, l'amplitude de ces raies étant liée aux erreurs de gain entre voies 6 ;

- les erreurs de phase correspondant aux erreurs de calage temporel des horloges provoquant dans le spectre du signal numérique 5 l'apparition de raies, aux fréquences $k\dfrac{F_e}{N} \pm F_{in}$ pour k variant de 0 à N-1 et $F_{in}$ étant la fréquence du signal analogique 2, l'amplitude de ces raies étant liée aux erreurs de phase de l'horloge et proportionnelle à la fréquence du signal analogique 2 ;

- les erreurs de bande passante correspondant aux différences de bande passante analogique provoquant dans le spectre du signal numérique 5 l'apparition de raies, aux fréquences $k\dfrac{F_e}{N} \pm F_{in}$ pour k variant de 0 à N - 1 et $F_{in}$ étant la fréquence du signal analogique 2, ces erreurs se combinant avec les erreurs de gain et de phase mais de manière non-linéaire.

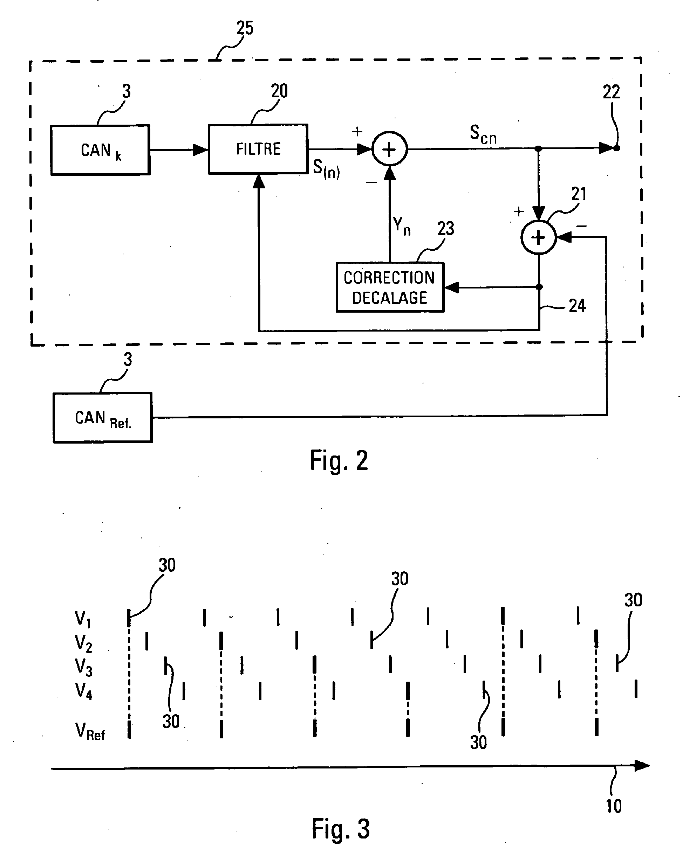

La figure 2 montre par un synoptique la structure d'une voie du dispositif de conversion analogique numérique selon l'invention. Les éléments identiques aux éléments déjà présentés sur les autres figures portent les mêmes références. Le dispositif de conversion analogique numérique selon l'invention est un convertisseur analogique numérique à entrelacement temporel, comportant N convertisseurs analogique numérique 3 en parallèle, chacun travaillant à une fréquence d'échantillonnage $\frac{F_e}{N}$. La figure 2 montre notamment le détail d'une voie 25 donnée du dispositif selon l'invention parmi les N voies 25 du dispositif de conversion analogique numérique selon l'invention. Les voies 25 remplacent dans le dispositif de conversion analogique numérique selon l'invention les voies 6 d'un convertisseur numérique analogique à entrelacement temporel selon l'état de l'art. Sur la figure 2, la voie 25 représentée est la k-ième. Bien sûr, les autres voies adoptent une structure identique. Aussi, la voie k comporte un convertisseur analogique numérique 3 nommé $CAN_k$. Une voie de référence N + 1 est ajoutée. Cette voie de référence N + 1 comporte notamment un convertisseur analogique numérique 3 nommé $CAN_{ref}$. La voie de référence génère des échantillons du signal analogique 2.

La voie k donnée comporte un filtre 20 assurant la fonction de réduction de l'erreur du signal délivré par le convertisseur analogique numérique $CAN_k$. Le filtre 20 est un filtre égaliseur. Le filtre 20 reçoit donc d'une part le signal numérique délivré par le convertisseur analogique numérique $CAN_k$ et d'autre part un signal d'erreur 24, noté $err_n$ pour un instant n donné. Le filtre 20 délivre en sortie un signal numérique filtré s(n) corrigé des erreurs déduites du signal d'erreur 24. Le signal d'erreur 24 correspond à l'écart à un instant donné entre d'une part le signal numérique corrigé par le filtre 20 et par un dispositif de correction du décalage 23 et d'autre part par le signal numérique délivré par le convertisseur analogique numérique $CAN_{ref}$ de la voie de référence N+1. Le filtre 20 est auto-adaptatif : les coefficients dudit filtre 20 s'ajustent automatiquement pour présenter la réponse qui minimise au mieux le signal d'erreur 24. Ceci permet de s'adapter aux variations de caractéristiques des convertisseurs analogique numérique 3 qui peuvent se produire par exemple dans le temps ou lors de variations de température. Le filtre 30 peut par exemple être un filtre à réponse impulsionnelle finie. Le dispositif de correction du décalage 23 permet de corriger l'erreur de décalage du signal numérique filtré s(n). Le dispositif de correction du décalage 23 délivre un signal d'erreur de décalage $Y_n$. Le signal d'erreur de décalage $Y_n$ peut par exemple être généré à un instant n en appliquant la relation mathématique suivante : $y_{n+1} = y_n + err_n * \mu$ à l'instant n avec $\mu$ une valeur de paramétrage, le signal numérique corrigé $S_{cn}$ est calculé en appliquant la relation mathématique suivante : $S_{cn} = s(n) - y_n$. De la valeur de $\mu$ dépend la rapidité de convergence et l'amplitude de l'erreur résiduelle.

Dans le cas où le filtre 20 est un filtre à réponse impulsionnelle finie, pour l'adaptation des coefficients dudit filtre 20, il est possible d'utiliser un algorithme de gradient (ou selon l'expression anglo-saxonne Least Mean Squares Algorithm ). Lorsque le filtre 20 comporte 2.q + 1 (q étant un entier) coefficients notés $C_{-q}$, $C_{-q+1}$, ...$C_o$, $C_1$...$C_q$, la sortie du filtre 20 à un instant k est donnée par la relation suivante $Y_k = \sum_{j=-q}^{+q} C_j x_{k-j}$ , $x_k$ étant l'entrée du filtre 20 à l'instant k. L'algorithme du gradient peut s'écrire grâce à la relation mathématique suivante : $C_j(k+1) = C_j(k) - \alpha.x_{k-j}.err_k$, $x_{k-j}$ étant l'échantillon d'entrée présent au niveau du j-ème coefficient à l'instant k, $\alpha$ représentant le pas de l'algorithme (de sa valeur va dépendre la rapidité de convergence et l'amplitude de l'erreur résiduelle). Si aucune correction n'est à effectuer les coefficients seront tous nuls sauf le coefficient central $C_0$ qui vaudra 1. Le filtrage se fait à une fréquence de $\frac{F_e}{N}$ tandis que l'adaptation des coefficients se fait à $\frac{F_e}{N(N+1)}$. Cet algorithme peut être simplifié en remplaçant $x_{k-j}$ par son signe ou l'erreur par son signe ou les deux par leurs signes. On obtient alors l'un des trois algorithmes suivants représentés par les relations suivantes :

$$C_j(k+1) = C_j(k) - \alpha.\mathrm{sgn}(x_{k-j}).err_k$$

$$C_j(k+1) = C_j(k) - \alpha.x_{k-j}.\mathrm{sgn}(err_k)$$

$$C_j(k+1) = C_j(k) - \alpha.\mathrm{sgn}(x_{k-j}).\mathrm{sgn}(err_k).$$

Ceci permet de simplifier les calculs surtout dans le dernier cas où l'adaptation des coefficients revient à ajouter ou à retrancher $\alpha$ au coefficient précédent ou à ne rien faire selon les signes respectifs de $x_{k-j}$ et de $err_k$.

Un dispositif de conversion numérique analogique selon l'invention comporte autant de voie 25 que nécessaire.

Ainsi, un dispositif de conversion analogique numérique selon l'invention disposera par exemple de 4 convertisseurs numérique analogique 3 en parallèle réparties sur 4 voies 25, chacun travaillant à une fréquence d'échantillonnage $\frac{F_e}{4}$. Ce dispositif de conversion numérique analogique selon l'invention comportera en outre une voie de référence 4+1. Chaque voie 25 comportera de plus un filtre 20, chaque filtre 20 assurant la fonction d'égalisation utilisant la voie de référence 4 + 1.

La figure 3 illustre par un chronogramme les instants d'échantillonnage des convertisseurs numérique analogique des différentes voies d'un dispositif de conversion analogique numérique selon l'invention. Les éléments identiques aux éléments déjà présentés sur les autres figures portent les mêmes références. Le dispositif de conversion analogique numérique selon l'invention comporte N convertisseurs numérique analogique 3 en parallèle répartis sur N voies 25, chacun travaillant à une fréquence d'échantillonnage $\frac{F_e}{N}$ et la voie de référence N + 1. Les instants d'échantillonnage des N premières voies respectent les contraintes d'un système à entrelacement temporel.

Le chronogramme comporte un axe des abscisses 10 représentant le temps. Des barres verticales 30 symbolisent pour chaque voie 6 les instants où des échantillons numériques sont construits. La figure 3 illustre l'exemple d'un dispositif de conversion analogique numérique selon l'invention disposant de 4 convertisseurs numérique analogique 3 en parallèle répartis sur 4 voies 25 nommées $V_1$, $V_2$, $V_3$ et $V_4$ et d'une voie de référence N+1 nommée $V_{ref}$.

Les échantillons de la voie de référence $V_{ref}$ du signal analogique 2 sont produits aux mêmes instants que les échantillons de l'une des voies $V_1$, $V_2$, $V_3$, $V_4$. De plus, si à un instant donné l'échantillonnage sur la voie de référence $V_{ref}$ se fait en même temps que celui de la voie $V_1$, le prochain échantillonnage aura lieu en même temps que celui de la voie $V_2$.

Entre les deux échantillons se sera écoulée une période sensiblement égale à une période d'horloge à $\frac{F_e}{5}$. Ensuite, le prochain échantillonnage aura lieu en même temps que celui de la voie 6 $V_3$. Entre les deux échantillons se sera écoulée une période sensiblement égale à une période d'horloge $\frac{F_e}{5}$. Puis, le prochain échantillonnage aura lieu en même temps que celui de la voie $V_4$. Entre les deux échantillons se sera écoulée une période sensiblement égale à une période d'horloge à $\frac{F_e}{5}$. Enfin, le prochain échantillonnage aura lieu en même temps que celui de la voie $V_1$.

Entre les deux échantillons se sera écoulée une période sensiblement égale à une période d'horloge à $\frac{F_e}{5}$. Le cycle recommence alors.

De manière plus générale, une fois que le convertisseur analogique numérique 3 de la voie de référence a généré un échantillon au même instant que la voie 25 disposée en $i^{ème}$ position avec i compris entre 1 et N, le convertisseur analogique numérique 3 de la voie de référence génèrera un échantillon au même instant que sur la voie 25 disposée en (i+1 modulo N)$^{ème}$ position. La fréquence de l'horloge d'échantillonnage sur la voie de référence est sensiblement égale à $\frac{F_e}{N+1}$. Pour une voie 25 donnée, on aura un échantillon tous les N × (N + 1) échantillons soit avec une périodicité égale à $\frac{N \times (N+1)}{F_e}$.

Dans un mode de réalisation particulièrement avantageux, le filtre 20 est un filtre à réponse impulsionnelle finie. Lorsque le filtre 20 comporte 2.q + 1 (q étant un entier) coefficients notés $C_{-q}$, $C_{-q+1}$, ...$C_o$, $C_1$...$C_q$, la sortie du filtre 20 à un instant k est donnée par la relation suivante $Y_k = \sum_{j=-q}^{+q} C_j x_{k-j}$, $x_k$ étant l'entrée du filtre 20 à l'instant k. Le gain du filtre est déterminé par le coefficient $C_0$. En supposant celui-ci égal à 1, le filtre 20 a une réponse fréquentielle définie par la relation $H(f)=e^{-j2\pi\delta t}$ soit un gain de 1 et un déphasage égal à $-2\pi f\delta t$. La réponse impulsionnelle à un instant t = i/Fe du filtre 20 peut être estimée, en considérant que $Fe\delta t$ est très inférieur à 1, par la relation mathématique suivante :

$$s(i) \approx (-1)^{i+1} \frac{F_e \delta t}{i}$$ pour i différent de 0 et si $\delta t$ est l'erreur sur l'horloge d'échantillonnage à $\frac{F_e}{N}$ (c'est-à-dire que l'échantillonnage au niveau du convertisseur analogique numérique 3 de la voie 6 se fait avec un retard de $\delta t$ secondes). De plus, le filtre 20 est antisymétrique ($s(i) = -s(-i)$). La valeur à un instant $i$ de la réponse impulsionnelle $s(i)$ du filtre 20 peut donc être définie par les deux relations suivantes :

$$s(1) = Fe.\delta t \quad et \quad \frac{s(1)}{s(i)} = (-1)^{i+1} i.$$

Le terme $s(i)$ de la réponse impulsionnelle à l'instant $i$ est obtenu en divisant le terme $s(1)$ par $i$ si $i$ est impair et par $-i$ si $i$ est pair. Les filtres à réponse impulsionnelle finie ont pour particularité d'être composés de coefficients correspondant directement aux termes de la réponse impulsionnelle à des instants $t = \frac{F_e}{N}$. Ainsi le coefficient central $C_0$ correspond à la réponse impulsionnelle à l'instant $t = 0$ et le coefficient $C_1$ à la réponse à l'instant $t = \frac{1}{F_e}$ et plus généralement $C_i = s(i)$. Les autres coefficients peuvent donc être ainsi directement déduits du coefficient $C_1$. Le filtre 20 étant un filtre auto-adaptatif, le coefficient central $C_0$ ainsi que le premier coefficient $C_1$ sont mis à jour automatiquement par une méthode d'auto adaptation, par exemple en utilisant l'algorithme du gradient, présenté précédemment. Le coefficient $C_{-1}$ est égal à $-C_1$. Les coefficients $C_{-i}$, pour $i$ variant de 2 à q, sont quant à eux égaux à $-C_i$. Lles coefficients $C_i$, pour $i$ variant de 2 à q, sont déterminés à partir de $C_1$ par la relation suivante : $C_i = \frac{C_1}{-i}$ pour $i$ pair et $C_i = \frac{C_1}{i}$ pour $i$ impair. Procéder de la sorte permet de forcer l'égaliseur à converger vers une réponse impulsionnelle donnée dépendant uniquement de l'erreur du signal d'entrée et indépendante de ses autres caractéristiques telles que sa fréquence.

En outre, l'invention ne se limite pas aux relations présentées ci-dessus entre les coefficients $C_i$. En effet, les coefficients $C_i$ sont définis par une relation fixée entre eux. Dans un mode particulier de réalisation, pour éviter des ondulations dans la réponse causées par la troncature de celle-ci, chaque coefficient $C_i$ est pondéré par un facteur $k(i)$ quasiment égal à 1 pour les coefficients centraux et décroissant vers zéro en allant vers les coefficients extrêmes, c'est-à-dire pour les coefficients $C_i$ avec $i$ tendant vers $2q+1$. Le facteur $k(i)$ est donc décroissant et varie sensiblement de 1 pour $i$ proche de 2 vers zéro pour $i$ tendant vers $2q+1$. La relation entre les coefficients $C_i$ est alors égale devient $C_i = \frac{k(i).C_1}{((-1)^{i+1}.i)}$ avec $k(i)$ dépendant de $i$.

Chaque convertisseur analogique numérique 3 fonctionne à une fréquence d'échantillonnage $\frac{F_e}{N}$, et par conséquent, chacun des filtres 20 assurant notamment la fonction d'égaliseur aussi. Le spectre du signal numérique corrigé $S_{cn}$ présente donc un repliement autour de la fréquence $\frac{F_e}{N}$, la bande de Nyquist valant $\frac{F_e}{2N}$. L'égalisation ne se fera correctement que dans cette bande de $\frac{F_e}{2N}$ qui peut être étroite si N est grand. Dans un mode de réalisation du convertisseur analogique numérique selon l'invention, pour remédier à cela, les filtres 20 assurant la fonction d'égalisation fonctionnent à la fréquence d'échantillonnage souhaitée $F_e$ au lieu de $\frac{F_e}{N}$. L'égalisation fonctionne alors correctement dans une bande de fréquence de largeur $\frac{F_e}{2}$. Pour ce faire, il est nécessaire de sur-échantillonner dans un rapport N à l'entrée du filtre 20. Pour cela on peut créer les N - 1 échantillons manquants entre deux échantillons par interpolation. Dans un mode de réalisation plus avantageux, plutôt que d'essayer d'interpoler les échantillons manquants, les échantillons disponibles à un instant donné sur l'une des autres voies 25 sont utilisés. Les données alimentent alors le filtre 20 à la fréquence d'échantillonnage souhaitée $F_e$. Cependant, un échantillon sur N seulement est utilisé en sortie du filtre 20.

A titre d'exemple, une réalisation possible du dispositif de conversion analogique numérique selon l'invention comporte 4 convertisseurs numérique analogique 3 fonctionnant à une fréquence d'échantillonnage de 250 MHz. Le convertisseur numérique analogique selon l'invention a donc une fréquence d'échantillonnage de 1 GHz. Les filtres 20 assurant la fonction d'égalisation de chaque voie 25 peuvent par exemple être mis en oeuvre dans un ou plusieurs circuits logiques, programmables ou non.

## Revendications

1. Dispositif de conversion analogique numérique recevant en entrée (1) un signal analogique (2) délivrant en sortie (4) un signal numérique (5) à une fréquence d'échantillonnage souhaitée ($F_e$), ledit dispositif comportant un nombre N de convertisseurs analogique numérique (3) répartis en N voies (25), chaque convertisseur analogique numérique (3) ayant une fréquence d'échantillonnage N fois plus faible que la fréquence d'échantillonnage souhaitée ($F_e$), lesdits convertisseurs analogique numérique (3) ayant des signaux d'horloge pilotant leur fréquence d'échantillonnage décalés temporellement les uns par rapport aux autres d'une période ($\Delta$) d'un signal de fréquence d'échantillonnage souhaitée ($F_e$), le signal numérique (5) étant construit à partir des échantillons délivrés en sortie de chaque voie (25), le dispositif comprenant en outre une voie de référence comportant un convertisseur analogique numérique (3) générant des échantillons du signal analogique (2), chaque voie (25) comportant un filtre (20) égaliseur, ledit filtre (20) recevant en entrée un signal numérique délivré par le convertisseur analogique numérique (3) de la voie (25) sur laquelle il est situé et un signal d'erreur (24), ledit filtre délivrant en sortie un signal numérique filtré s(n) corrigé des erreurs déduites du signal d'erreur (24), le signal d'erreur (24) correspondant à l'écart à un instant donné entre d'une part le signal numérique corrigé par le filtre (20) et d'autre part le signal numérique délivré par le convertisseur analogique numérique (3) de la voie de référence, les coefficients dudit filtre (20) s'ajustant pour présenter la réponse qui minimise au mieux le signal d'erreur (24), le dispositif étant **caractérisé en ce que** le filtre (20) de chaque voie (25) est un filtre à réponse impulsionnelle finie auto adaptatif, ledit filtre (20) comportant 2.q + 1 coefficients $C_i$, q étant un entier, le coefficient central $C_0$ et le premier coefficient $C_1$ du filtre (20) étant mis à jour par une méthode d'auto adaptation, le coefficient $C_{-1}$ étant égal à - $C_1$, les coefficients $C_{-i}$, pour i variant de 2 à q, étant égaux à - $C_i$ et les coefficients $C_i$, pour i variant de 2 à q, étant déterminés à partir de $C_1$ par la relation suivante :

$$C_i = \frac{C_1}{-i} \text{ pour i pair et } C_i = \frac{C_1}{i} \text{ pour i impair.}$$

2. Dispositif selon la revendication 1 **caractérisé en ce que** le signal d'erreur (24) correspond à l'écart à un instant donné entre d'une part le signal numérique corrigé à la fois par le filtre (20) et par un dispositif de correction du décalage (23) et d'autre part par le signal numérique délivré par le convertisseur analogique numérique (3) de la voie de référence, ledit dispositif de correction du décalage (23) délivrant un signal d'erreur de décalage $Y_n$, ledit signal d'erreur de décalage $Y_n$ étant généré à un instant n en appliquant la relation mathématique suivante : $y_{n+1} = y_n + err_n * \mu$ à l'instant n avec $err_n$ la valeur du signal d'erreur (24) à un instant n et $\mu$ une valeur de paramétrage.

3. Dispositif selon l'une des quelconques revendications précédentes **caractérisé en ce qu'**une fois que le convertisseur analogique numérique (3) de la voie de référence a généré un échantillon au même instant que la voie (25) disposée en $i^{ème}$ position avec i compris entre 1 et N, le convertisseur analogique numérique (3) de la voie de référence génèrera le prochain échantillon au même instant que sur la voie (25) disposée en (i+1 modulo N)$^{ème}$ position.

4. Dispositif selon l'une quelconque des revendications précédentes **caractérisé en ce que** l'adaptation des coefficients $C_i$ des filtres (20) de chaque voie (25) est réalisée par un algorithme de gradient.

5. Dispositif selon l'une des quelconques revendications précédentes **caractérisé en ce que** chaque coefficient $C_i$ est pondéré par un facteur k(i) dépendant de i.

6. Dispositif selon la revendication 5 **caractérisé en ce que** le facteur k(i) est décroissant et varie sensiblement de 1 pour i proche de 2 vers zéro pour i tendant vers 2q+1.

7.  Dispositif selon l'une des quelconques revendications précédentes **caractérisé en ce que** le filtre (20) de chaque voie (25) fonctionne à la fréquence d'échantillonnage souhaitée ($F_e$), en sur-échantillonnant dans un rapport N à l'entrée dudit filtre (20).

8.  Dispositif selon la revendication 7 **caractérisé en ce que** les échantillons disponibles à un instant donné sur l'une des autres voies (25) sont utilisés à l'entrée dudit filtre (20), les échantillons alimentant le filtre (20) à la fréquence d'échantillonnage souhaitée ($F_e$).

**Claims**

1.  Analogue digital conversion device receiving as input (1) an analogue signal (2) delivering as output (4) a digital signal (5) at a desired sampling frequency ($F_e$), the said device comprising a number N of analogue digital converters (3) distributed in N pathways (25), each analogue digital converter (3) having a sampling frequency N times lower than the desired sampling frequency ($F_e$), the said analogue digital converters (3) having clock signals driving their sampling frequency that are shifted temporally with respect to one another by a period ($\Delta$) of a signal of desired sampling frequency ($F_e$), the digital signal (5) being constructed on the basis of the samples delivered as output from each pathway (25), the device furthermore comprising a reference pathway comprising an analogue digital converter (3) generating samples of the analogue signal (2), each pathway (25) comprising an equalizer filter (20), the said filter (20) receiving as input a digital signal delivered by the analogue digital converter (3) of the pathway (25) on which it is situated and an error signal (24), the said filter delivering as output a filtered digital signal s(n) corrected for the errors deduced from the error signal (24), the error signal (24) corresponding to the deviation at a given instant between on the one hand the digital signal corrected by the filter (20) and on the other hand the digital signal delivered by the analogue digital converter (3) of the reference pathway, the coefficients of the said filter (20) adjusting themselves so as to exhibit the response which best minimizes the error signal (24), the device being **characterized in that** the filter (20) of each pathway (25) is an auto-adaptive finite impulse response filter, the said filter (20) comprising $2.q + 1$ coefficients $C_i$, q being an integer, the central coefficient $C_0$ and the first coefficient $C_1$ of the filter (20) being updated by an auto-adaptation scheme, the coefficient $C_{-1}$ being equal to $-C_1$, the coefficients $C_{-i}$, for i varying from 2 to q, being equal to $-C_i$ and the coefficients $C_i$, for i varying from 2 to q, being determined from $C_1$ by the following relation: $C_i = C_1/-i$ for i even and $C_i = C_1/i$ for i odd.

2.  Device according to Claim 1, **characterized in that** the error signal (24) corresponds to the deviation at a given instant between on the one hand the digital signal corrected at one and the same time by the filter (20) and by a device for correcting the shift (23) and on the other hand by the digital signal delivered by the analogue digital converter (3) of the reference pathway, the said device for correcting the shift (23) delivering a shift error signal $Y_n$, the said shift error signal $Y_n$ being generated at an instant n by applying the following mathematical relation: $y_{n+1} = y_n + err_n * \mu$ at the instant n with $err_n$ the value of the error signal (24) at an instant n and $\mu$ a parametrization value.

3.  Device according to any one of the preceding claims, **characterized in that** once the analogue digital converter (3) of the reference pathway has generated a sample at the same instant as the pathway (25) disposed in $i^{th}$ position with i lying between 1 and N, the analogue digital converter (3) of the reference pathway will generate the next sample at the same instant as on the pathway (25) disposed in (i+1 modulo N) $^{th}$ position.

4.  Device according any one of the preceding claims, **characterized in that** the adaptation of the coefficients $C_i$ of the filters (20) of each pathway (25) is carried out by a gradient algorithm.

5.  Device according to any one of the preceding claims, **characterized in that** each coefficient $C_i$ is weighted by a factor k(i) dependent on i.

6.  Device according to Claim 5, **characterized in that** the factor k(i) is decreasing and varies substantially from 1 for i close to 2 to zero for i tending to 2q+1.

7.  Device according to any one of the preceding claims, **characterized in that** the filter (20) of each pathway (25) operates at the desired sampling frequency ($F_e$), by oversampling in a ratio N at the input of the said filter (20).

8.  Device according to Claim 7, **characterized in that** the samples available at a given instant on one of the other pathways (25) are used at the input of the said filter (20), the samples supplying the filter (20) at the desired sampling frequency ($F_e$).

**Patentansprüche**

1. Vorrichtung zur Analog-Digital-Umwandlung, die am Eingang (1) ein analoges Signal (2) empfängt und am Ausgang (4) ein digitales Signal (5) mit einer gewünschten Abtastfrequenz ($F_e$) liefert, wobei die Vorrichtung eine Anzahl N von Analog-Digital-Wandlern (3) aufweist, die in N Kanälen (25) verteilt sind, wobei jeder Analog-Digital-Wandler (3) eine Abtastfrequenz hat, die N mal geringer ist als die gewünschte Abtastfrequenz ($F_e$), wobei die Analog-Digital-Wandler (3) ihre Abtastfrequenz steuernde Taktsignale haben, die zeitlich zueinander um eine Periode ($\Delta$) eines gewünschten Abtastfrequenzsignals ($F_e$) verschoben sind, wobei das digitale Signal (5) ausgehend von den Tastproben aufgebaut wird, die am Ausgang jedes Kanals (25) geliefert werden, wobei die Vorrichtung außerdem einen Referenzkanal aufweist, der einen Analog-Digital-Wandler (3) enthält, der Tastproben des analogen Signals (2) erzeugt, wobei jeder Kanal (25) ein Entzerrerfilter (20) aufweist, wobei das Filter (20) am Eingang ein digitales Signal, das vom Analog-Digital-Wandler (3) des Kanals (25) geliefert wird, auf dem es sich befindet, und ein Fehlersignal (24) empfängt, wobei das Filter am Ausgang ein gefiltertes digitales Signal s(n) liefert, bei dem die vom Fehlersignal (24) abgeleiteten Fehler korrigiert sind, wobei das Fehlersignal (24) der Abweichung in einem bestimmten Zeitpunkt zwischen einerseits dem vom Filter (20) korrigierten digitalen Signal und andererseits dem vom Analog-Digital-Wandler (3) des Referenzkanals gelieferten digitalen Signal entspricht, wobei die Koeffizienten des Filters (20) sich einstellen, um die Antwort aufzuweisen, die das Fehlersignal (24) am besten minimiert, wobei die Vorrichtung **dadurch gekennzeichnet ist, dass** das Filter (20) jedes Kanals (25) ein autoadaptives Filter mit endlicher Impulsantwort ist, wobei das Filter (20) $2.q + 1$ Koeffizienten $C_i$ aufweist, wobei q eine ganze Zahl ist, wobei der zentrale Koeffizient $C_0$ und der erste Koeffizient $C_1$ des Filters (20) durch eine Autoadaptierungsmethode aktualisiert werden, wobei der Koeffizient $C_{-1}$ gleich $-C_1$ ist, wobei die Koeffizienten $C_{-i}$, für i von 2 bis q variierend, gleich $-C_i$ sind, und die Koeffizienten $C_i$, für i von 2 bis q variierend, ausgehend von $C_1$ durch die folgende Beziehung bestimmt werden: $C_i = \dfrac{C_1}{-i}$ für i eine gerade Zahl, und $C_i = \dfrac{C_1}{i}$ für i eine ungerade Zahl.

2. Vorrichtung nach Anspruch 1, **dadurch gekennzeichnet, dass** das Fehlersignal (24) der Abweichung in einem gegebenen Zeitpunkt zwischen einerseits dem digitalen Signal, das sowohl von dem Filter (20) als auch von einer Korrekturvorrichtung der Verschiebung (23) korrigiert wird, und andererseits dem digitalen Signal entspricht, das vom Analog-Digital-Wandler (3) des Referenzkanals geliefert wird, wobei die Korrekturvorrichtung der Verschiebung (23) ein Verschiebungs-Fehlersignal $Y_n$ liefert, wobei das Verschiebungs-Fehlersignal $Y_n$ in einem Zeitpunkt n erzeugt wird, indem die folgende mathematische Beziehung an den Zeitpunkt n angewendet wird: $y_n +_1 Y_n + err_n {}^* \mu$, mit $err_n$ dem Wert des Fehlersignals (24) in einem Zeitpunkt n und $\mu$ einem Parametrierwert.

3. Vorrichtung nach einem der vorhergehenden Ansprüche, **dadurch gekennzeichnet, dass**, wenn der Analog-Digital-Wandler (3) des Referenzkanals eine Tastprobe im gleichen Zeitpunkt wie der Kanal (25) erzeugt hat, der in der i-ten Stellung mit i zwischen 1 und N angeordnet ist, der Analog-Digital-Wandler (3) des Referenzkanals die nächste Tastprobe im gleichen Zeitpunkt wie in dem Kanal (25) erzeugen wird, der in der (i+1 Modulo N)-ten Stellung angeordnet ist.

4. Vorrichtung nach einem der vorhergehenden Ansprüche, **dadurch gekennzeichnet, dass** die Adaptierung der Koeffizienten $C_i$ der Filter (20) jedes Kanals durch einen Gradient-Algorithmus durchgeführt wird.

5. Vorrichtung nach einem der vorhergehenden Ansprüche, **dadurch gekennzeichnet, dass** jeder Koeffizient $C_i$ mit einem von i abhängenden Faktor k(i) gewichtet wird.

6. Vorrichtung nach Anspruch 5, **dadurch gekennzeichnet, dass** der Faktor k(i) abnimmt und im Wesentlichen um 1 variiert für i nahe 2 zu Null für i zu 2q+l tendierend.

7. Vorrichtung nach einem der vorhergehenden Ansprüche, **dadurch gekennzeichnet, dass** das Filter (20) jedes Kanals (25) mit der gewünschten Abtastfrequenz ($F_e$) arbeitet, indem es in einem Verhältnis N am Eingang des Filters (20) überabtastet.

8. Vorrichtung nach Anspruch 7, **dadurch gekennzeichnet, dass** die in einem gegebenen Zeitpunkt auf einem der anderen Kanäle (25) verfügbaren Tastproben am Eingang des Filters (20) verwendet werden, wobei die Tastproben das Filter (20) mit der gewünschten Abtastfrequenz ($F_e$) speisen.

Fig. 1a

Fig. 1b

Fig. 2

Fig. 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2004328436 A

- US 5239299 A

**Littérature non-brevet citée dans la description**

- **DYER K. et al.** Analog Background Calibration of a 10 b 40 Msample/s Parallel Pipelined ADC, Sol-id-State Circuits Conférence. *Digest of Technical Papers,* 05 Février 1998, 142-143427